# EUROPEAN PATENT APPLICATION

(11) **EP 3 300 469 A1**
(43) Date of publication of application: **28.03.2018**
(21) Application number: 17176262.8
(22) Date of filing: 15.06.2017
(51) Int. Cl.: H05K 3/28

(54) **METHOD FOR COATING DEVICE AND RESULTING DEVICE**

(30) Priority: 17.06.2016 US 201662351590 P; 31.08.2016 US 201662381915 P; 31.08.2016 US 201662381936 P; 02.06.2017 US 201715612182
(71) Applicant: Nano Shield Technology Co., Ltd., 10492 Taipei City (TW)
(72) Inventor: Cheng Lee, James, Diamond Bar, CA 91765 (US)
(74) Representative: Papula Oy

(57) **Abstract**

A method includes steps of forming an inner coating on an object and forming an outer coating in contact with the inner coating. A first solution including metal oxide nanoparticles and a first solvent is applied onto the object. The first solvent is removed to form the inner coating with the metal oxide nanoparticles. A second solution having silicon dioxide nanoparticles and a second solvent is applied onto the object. The second solvent is removed to form the outer coating with the silicon dioxide nanoparticles. The interfacial binding force between the metal oxide nanoparticles and the silicon dioxide nanoparticles is then strengthened, for example, by applying a third solution such as water, ethanol or a mixture thereof to the inner coating and the outer coating.

## Description

### FIELD OF THE INVENTION

The present subject matter generally relates to a method for fabricating a nanofilm, and more particularly to a method for forming a device with a nanofilm to protect the device from being corroded and moistened, and the resulting device.

### BACKGROUND

As electronic devices continue to shrink in size and grow in capacity, the importance of corrosion control increases. Miniaturization of systems based on integrated circuits and small size electronic components, close component spacing, separable electrical contacts having lower voltages and contact force than before have resulted in failures of electrical components because of the formation of small quantities of metal corrosion. Therefore, it is important to find a method for fabricating electronic devices with a superhydrophobic nanofilm coating. This technique can protect the device surface from being corroded and moistened by some exterior chemicals, and extend the operating life of the device. In addition, some other engineering systems such as aircraft, automobiles, pipelines, and naval vessels also need a protective nanofilm keeping them from being corroded and moistened, and providing less friction.

### SUMMARY OF THE INVENTION

The present disclosure provides a method for forming a coated object or forming a device, and the resulting coated object or device. The method comprises steps of forming an inner coating on an object and forming an outer coating in contact with the inner coating. The step of forming the inner coating comprises applying a first solution including metal oxide nanoparticles and a first solvent onto the object, and removing the first solvent to form the inner coating with the metal oxide nanoparticles. The step of forming the outer coating comprises applying a second solution including silicon dioxide nanoparticles and a second solvent onto the object, and removing the second solvent to form the outer coating with the silicon dioxide nanoparticles. The method further includes a step of strengthening a binding force between the metal oxide nanoparticles and the silicon dioxide nanoparticles. The binding force can be strengthened by applying a third solution such as water, ethanol or a combination thereof to the inner coating and the outer coating. In some embodiments, the metal oxide nanoparticles and the silicon dioxide nanoparticles are covalently bonded together in the interface between the inner coating and the outer coating. In each of the inner and outer coatings, nanoparticles may be bonded or fused together with each other, and may be in agglomerates.

An object of the present disclosure is to provide a method for preparing the first solution metal oxide nanoparticles. In some embodiments, the method includes the following steps. Metal powders and distilled water are added into a serum bottle. The pH value of the mixed solution is adjusted in the range of 6.5-9.5 through addition of an acidic solvent such as HNO₃, HF, H₂SO₄ or HCl, a neutral solvent such as IPA, acetone or alcohol, and/or an alkaline solvent such as NaOH, KOH, or NH₄OH. The mixed solution is heated under vigorous stirring at an appropriate temperature for a period of time, for example, at about 50°C to 150 °C for 10-20 hours. The mixed solution has metal oxide nanoparticles having a size or a size distribution in the range of several to hundreds of nanometers, such as about 5 nm to about 100 nm, at room temperature, and is hydrophilic and transparent.

An object of the present disclosure is to provide a method for preparing a second solution having silicon dioxide nanoparticles. In some embodiments, the method includes the following steps. Silica powders and distilled water are added into a serum bottle. The pH value of the mixed solution is adjusted in the range of 6.5-9.5 through addition of an acidic solvent such as HNO₃, HF, H₂SO₄ or HCl, organic solvents such as IPA, acetone or alcohol, and/or an alkaline solvent such as NaOH, KOH, or NH₄OH. An organic solvent such as n-hexane, n-heptane, n-octane, n-dodecane, n-tetradecane, or n-hexadecane, or any combination thereof is added into the mixed solution. The organic solvent may comprises a siloxane or silane. A metallic material such as Fe, Cr, Mn, or Mo is added as a catalyst into the mixed solution. The mixed solution is heated under vigorous stirring at an appropriate temperature for a period of time, for example, at about 50°C to 150 °C for 1-10 hours, forming a two-layer mixed solution where smaller-scale silicon dioxide nanoparticles existing in the top-layer mixed solution. The top layer of the mixed solution is extracted as the second solution. The second solution includes silicon dioxide nanoparticles having a size or size distribution in the range of from 1 angstrom to tens of nanometers, such as 0.1 nm to 50 nm at room temperature, and is transparent, hydrophobic, and low volatile.

An object of the present disclosure is to provide a method for fabricating an electronic device with a transparent superhydrophobic nanofilm coating. In some embodiments, the method includes the steps described herein. The electronic device is cleaned. The device is baked at an appropriate temperature for a period of time, for example, at about 50°C to 150 °C for 10-30 minutes. The first solution with metal oxide nanoparticles as a first solute is applied onto the electronic device by any means known in the art, such as spraying, dipping, roll coating, brushing, and the like. The size of the metal oxide nanoparticles is in a range of from several to hundreds of nanometers, such as from about 5 nm to about 100 nm. The electronic device coated with the first solution is baked at an appropriate temperature for a period of time, for example, at about 50°C to 150 °C for 5-30 minutes to form an inner coating on the electronic device with the metal oxide nanoparticles. Adhesive force between the inner coating and the electronic device is then strengthened. A second solution having silicon dioxide nanoparticles as a second solute is applied on the inner coating. The size of silicon dioxide nanoparticles is in a range of from 1 angstrom to tens of nanometers, such as 0.1 nm to 50 nm. The electronic device coated with the second solution is baked at an appropriate temperature for a period of time, for example, in a range of from about 50°C to 150 °C for 10-30 minutes to form as an outer coating with the silicon dioxide nanoparticles on the inner coating. Adhesive force between the inner coating and the outer coating is then strengthened.

Another object of the present disclosure is to provide a method for coating a printed circuit board assembly (PCBA). In some embodiments, the method includes the steps as described herein. The PCBA surface is cleaned. The PCBA is baked at an appropriate temperature for a period of time, for example, in the range of from about 50°C to 150 °C for 10-30 minutes. A first solution with metal oxide nanoparticles as a first solute is applied onto the PCBA by any means known in the art, such as spraying, dipping, roll coating, brushing, and the like. The size of the metal oxide nanoparticles is in a range of from several to hundreds of nanometers, such as from about 5 nm to about 100 nm. The PCBA coated with the first solution is baked at an appropriate temperature for a period of time, for example, at about 50°C to 150 °C for 5-30 minutes to form an inner coating on the PCBA with the metal oxide nanoparticles. Adhesive force between the inner coating and the PCBA is strengthened. A second solution having silicon dioxide nanoparticles as a second solute is then applied on the inner coating. The size of silicon dioxide nanoparticles is in the range of from 1 angstrom to tens of nanometers, such as 0.1 nm to 50 nm. The PCBA coated with the second solution is baked at an appropriate temperature for a suitable period of time, for example, at about 50 °C to 150 °C for 10-30 minutes to form an outer coating on the inner coating with the silicon dioxide nanoparticles. Adhesive force between the inner coating and outer coating is then strengthened.

A thickness of the nanofilm coated on the device can be from few nanometers to few microns, such as from 10 nm to 1 micron. The nanofilm may be composed of the titanium dioxide nanoparticles and the silicon dioxide nanoparticles. The diameter of silicon dioxide nanoparticles is smaller than that of titanium dioxide nanoparticles. The nanofilm consisting of larger titanium dioxide nanoparticles and smaller silicon dioxide nanoparticles exhibits hierarchical structure and high surface roughness, leading to the superhydrophobic property. The water contact angle *θ* of the nanofilm on the device surface is in the range of 90° < θ < 150°. In some embodiments, the nanofilm can make the device surface have less friction or other functions.

As described above, the nanofilm in the present disclosure is composed of larger-sized metal oxide nanoparticles and smaller-sized silicon dioxide nanoparticles, which can protect the PCBA from being corroded and moistened. The nanofilm allows the device it protected to have a good waterproof and corrosion resistance characteristics.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion. Like reference numerals denote like features throughout specification and drawings.
FIG. 1 is a schematic diagram of an electronic device having a printed circuit board assembly (PCBA) coated with a nanofilm in accordance with some embodiments of the present disclosure.
FIG. 2 is a flow chart showing an exemplary method for coating a PCBA in accordance with some embodiments of the present disclosure.
FIG. 3A is a picture illustrating water droplets formed on a glass substrate coated with a nanofilm consistent with embodiments of the present disclosure.
FIG. 3B is a close-look view of a tiny water droplet on a glass substrate coated with a nanofilm.
FIG. 4 illustrates measurement results of a particle size distribution of TiO₂ nanoparticles by a dynamic light scattering method at room temperature.
FIG. 5 illustrates another measurement results of a particle size distribution of TiO₂ nanoparticles by a dynamic light scattering method at room temperature.
FIG. 6 illustrates yet another measurement results of a particle size distribution of TiO₂ nanoparticles by a dynamic light scattering method at room temperature.
FIG. 7 illustrates another measurement results of a particle size distribution of TiO₂ nanoparticles by a dynamic light scattering method at room temperature.
FIG. 8 illustrates measurement results of a particle size distribution of SiO₂ nanoparticles by a dynamic light scattering method at room temperature.
FIG. 9 illustrates another measurement results of a particle size distribution of SiO₂ nanoparticles by a dynamic light scattering method at room temperature.
FIG. 10 illustrates yet another measurement results of a particle size distribution of SiO₂ nanoparticles by a dynamic light scattering method at room temperature.
FIG. 11 illustrates another measurement results of a particle size distribution of SiO₂ nanoparticles by a dynamic light scattering method at room temperature.
FIG. 12A-12C show three measurement results of particle size distribution of TiO₂ nanoparticles by a dynamic light scattering method according to an exemplary embodiment.
FIG. 13 shows transmission electron microscopy (TEM) images of SiO₂ nanoparticles and a particle size distribution diagram, according to an exemplary embodiment.
FIG. 14 is a flow chart illustrating an exemplary method for coating an object in accordance with some embodiments of the present disclosure.

### DETAILED DESCRIPTION OF THE PREFERRED EMBODIMENTS

The following disclosure provides many different embodiments, or examples, for implementing different features of the invention. Specific examples of components and arrangements are described below to simplify the present disclosure. These are, of course, merely examples and are not intended to be limiting. For example, the formation of a first feature over or on a second feature in the description that follows may include embodiments, in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

In the present disclosure the singular forms "a," "an," and "the" include the plural reference, and reference to a particular numerical value includes at least that particular value, unless the context clearly indicates otherwise. Thus, for example, a reference to "a PCBA" is a reference to one or more of such structures and equivalents thereof known to those skilled in the art, and so forth. Furthermore, when a sentence is recited "at least one of A, B and C", it can be interpreted to mean that any combination. For example, may be only "A", or "B", or "C", or "A and B", or "A and C", or "B and C", or "A and B and C."

When values are expressed as approximations, by use of the antecedent "about," it will be understood that the particular value forms another embodiment. As used herein, "about X" (where X is a numerical value) preferably refers to ±10 % of the recited value, inclusive. For example, the phrase "about 8" preferably refers to a value of 7.2 to 8.8, inclusive; as another example, the phrase "about 8%" preferably (but not always) refers to a value of 7.2 % to 8.8 %, inclusive. Where present, all ranges are inclusive and combinable.

For example, when a range of "1 to 5" is recited, the recited range should be construed as including ranges "1 to 4", "1 to 3", "1-2", "1-2 & 4-5", "1-3 & 5", "2-5", and the like. In addition, when a list of alternatives is positively provided, such listing can be interpreted to mean that any of the alternatives may be excluded, e.g., by a negative limitation in the claims. For example, when a range of "1 to 5" is recited, the recited range may be construed as including situations whereby any of 1, 2, 3, 4, or 5 are negatively excluded; thus, a recitation of "1 to 5" may be construed as "1 and 3-5, but not 2", or simply "wherein 2 is not included." It is intended that any component, element, attribute, or step that is positively recited herein may be explicitly excluded in the claims, whether such components, elements, attributes, or steps are listed as alternatives or whether they are recited in isolation.

Surface properties, such as morphology, roughness, and composition can affect the surface wetting characteristics, spanning the range from superhydrophilic to superhydrophobic. The superhydrophobic film can be formed by the deposition of larger sized nanoparticles followed by smaller sized nanoparticles in some embodiments. This surface structure shows high surface roughness that enables the trapping of air under water droplets, thereby exhibiting the rolling water droplet effect that is characteristic of a superhydrophobic surface.

Different techniques are used to fabricate a device with superhydrophobic nanofilms. These include sol-gel techniques, plasma-enhanced chemical vapor deposition (PECVD), and physical vapor deposition (PVD). For the sol-gel coating technique, solutions are used to create a hydrophobic film containing a mixture of micro- and nano- scale nanoparticles, which can prevent water from penetrating the device surface. However, it is difficult to control the aggregation and dispersion behavior of nanoparticles in solutions, resulting in thick films with low roughness.

For the PVD or PECVD techniques, the substrates are introduced to a vacuum chamber to first create a suitably micrometer-scale textured film on substrate surface that is subsequently deposited with nanometer-scale particles at a very low speed. The benefits of using PVD or PECVD techniques to grow hydrophobic materials onto a substrate might include the high quality of resultant surface structure. However, a key limiting factor in the development of PVD or PECVD techniques has been related cost. The high production cost for fabricating a device with superhydrophobic film has been an obstacle to compete with other techniques. Moreover, the precursor gases used in the fabrication process are very toxic and need to be removed by extreme levels of heat, which may damage the electronic device. Therefore, a method for forming a superhydrophobic film with high quality surface structure and low cost for electronic devices is required.

The present disclosure provides a method for forming a coated object or forming a device, and the resulting coated object or device. Such a method for forming a device comprises steps of forming an inner coating comprising metal oxide nanoparticles on an object by using a first solution comprising metal oxide nanoparticles and a first solvent, forming an outer coating in contact with the inner coating by using a second solution comprising silicon dioxide nanoparticles and a second solvent; and strengthening a binding force between the metal oxide nanoparticles and the silicon dioxide nanoparticles by applying a third solution onto the inner coating and the outer coating. In some embodiments, the third solution is distilled water, ethanol, or any combination thereof. The resulting object or device has a coated surface having superhydrophobic properties. In some embodiments, the metal oxide nanoparticles and the silicon dioxide nanoparticles are bonded, for example, covalently bonded together in the interface between the inner coating and the outer coating.

Unless expressly indicated otherwise, references to "metal oxide" made below will be understood to encompass any suitable oxide of any suitable metal. Examples of suitable metal oxides include, but are not limited to, the oxides of a metal (or a combination thereof) selected from the following groups: (1) Al, Ga, In, Sn, Tl, Pb, and Bi ("poor metals"); (2) the first series of transition metals (first d block series) including Sc, Ti, V, Cr, Mn, Fe, Co, Ni, Cu, and Zn; (3) the second series of transition metals (second d block series) including Y, Zr, Nb, Mo, Tc, Ru, Rh, Pd, Ag, and Cd; and (4) the third series of transition metals (third d block series) including Lu, Hf, Ta, W, Re, Os, Ir, Pt, Au, and Hg. More preferably, the metal for the metal oxides is selected from at least one of Al, Ti, Cr, Mn, Co, Zn, Mo, Rh, Pd, Ag, W and Au. For example, a suitable metal oxide is titanium dioxide TiO₂ in some embodiments.

A method provided in the present disclosure comprises steps of forming an inner coating on an object and forming an outer coating in contact with the inner coating. The step of forming the inner coating comprises applying a first solution including metal oxide nanoparticles and a first solvent onto the object, and removing the first solvent to form the inner coating with the metal oxide nanoparticles. The step of forming the outer coating comprises applying a second solution including silicon dioxide nanoparticles and a second solvent onto the object, and removing the second solvent to form the outer coating with the silicon dioxide nanoparticles. The method further includes a step of strengthening a binding force between the metal oxide nanoparticles and the silicon dioxide nanoparticles. The binding force can be strengthened by applying a third solution such as water, ethanol or a combination thereof to the inner coating and the outer coating. The third solution may be applied by at least one technique selected from the group consisting of dipping, spraying and brushing for a period of time, for example, in a range of from about 10 seconds to about 30 seconds. In some embodiments, the third solution (e.g., deionized water or distilled water) is applied to the inner coating and the outer coating, for example, by immersion at a temperature in a range of from about 50 °C to about 80 °C.

In some embodiments, the first solvent is removed by heating the object at a first temperature for a first period of time. The first temperature may be in a range of from about 50 °C to 150 °C. The first period of time may be in a range of from about 5 minutes to about 30 minutes.

The method may further comprise masking steps. For example, in some embodiments, one or more portions of the object are masked with a masking material before the first solution is applied onto the object. After the outer coating is formed, the masking material is removed to expose the one or more portions of the object. In some embodiments, one or more portions of the inner coating on the object are masked with a masking material before the second solution is applied onto the object. After the outer coating is formed, the masking material is removed from the one or more portions of the inner coating to expose one or more portions of the inner coating.

The method may further comprise steps of heating treatments after the inner coating is formed and before the outer coating is formed. In some embodiments, the object coated with the inner coating is baked at a second temperature for a second period of time after the inner coating is formed. The first temperature is higher than the second temperature. The first period of time is shorter than the second period of time. For example, the second temperature is in a range of from about 25 °C to about 100 °C. The second period of time is a range of from about 2 hours to about 72 hours. In some embodiments, the object coated with the inner coating is baked at a third temperature for a third period of time after baking the object at the second temperature for the second period of time. The third temperature is higher than the second temperature. The third period of time is shorter than the second period of time. For example, the second temperature is in a range of from about 50 °C to about 150 °C, and the second period of time is a range of from about 10 minutes to about 30 minutes.

In some embodiments, the second solvent is removed by heating the object at a fourth temperature for a fourth period of time. In some embodiments, the fourth temperature is higher than the second temperature, and the fourth period of time is shorter than the second period of time. For example, the fourth temperature is in a range of from about 50 °C to 150 °C, and the fourth period of time is in a range of from about 10 minutes to about 30 minutes.

In some embodiments, the third solution is pure water, ethanol, or any combination thereof. The metal oxide nanoparticles comprise TiO₂, and the third solution is pure water. The method may further comprises drying the object to remove the third solution in excess.

In another aspect, the present disclosure provides a coated object. The coated object comprises an inner coating comprising metal oxide nanoparticles disposed on a surface of an object, and an outer coating comprising silicon dioxide nanoparticles in contact with the inner coating. The metal oxide nanoparticles and the silicon dioxide nanoparticles are bonded together in an interface between the inner coating and the outer coating. In some embodiments, the metal oxide nanoparticles and the silicon dioxide nanoparticles are covalently bonded together in the interface between the inner coating and the outer coating.

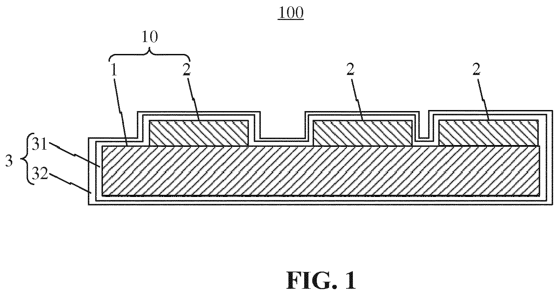

FIG. 1 illustrates a schematic diagram of an exemplary electronic device 100, according to some embodiments. The electronic device 100 comprises a printed circuit board assembly (PCBA) 10 and a nanofilm 3 coated on the PCBA 10. The PCBA 10 includes a printed circuit board (PCB) 1, one or more electronic components 2 mounted thereon. In some embodiments. the peripheries and surfaces of the PCB 1 and the electronic components 2 are rough. In manufacturing process of the PCBA 10 and the electronic components 2, a plurality of pores, gaps and other structures, which make the PCBA 10 and the electronic components 2 rough, are formed. Each of the electronic components 2 may have a plurality of pins electrically connected with the printed circuit board 1. The pins comprise a conductive material such as a metal in some embodiments.

The electronic components 2 can be a resistor, a capacitor, an inductor, a transistor, a diode, a connector, a speaker, a microphone and any other components which can be mounted on the printed circuit board 1. The printed circuit board assembly 10 may be applied in a pack battery, a headset, a phone or any other electronic devices. The printed circuit board 1 is made from a FR-4 composite material, which is a glass-reinforced epoxy composite, in some embodiments.

In some embodiments. the nanofilm 3 comprises an inner coating 31 comprising metal oxide nanoparticles, and an outer coating 32 comprising silicon dioxide nanoparticles having a size smaller than that of the metal oxide nanoparticles. The inner coating 31 comprises the metal oxide nanoparticles is disposed on or in contact with the PCB 1 and the electronic components 2 of the PCBA 10. The outer coating 32 comprising the silicon dioxide nanoparticles is disposed on or in contact with the inner coating 31.

The shapes of the inner coating 31, the outer coating 32, and the PCBA 10 shown on FIG. 1 are merely schematic. In some embodiments, the periphery of the inner coating 31 has a plurality of tiny pores, gaps and other structures. When the outer coating 32 is formed on the inner coating 31, there may be interpenetration between the outer coating 32 and the inner coating 31. In some embodiments, the outer coating 32 and the inner coating 31 may not be two separate layers. The metal oxide nanoparticles and the silicon dioxide nanoparticles can form the nanofilm 3 within the same layer. The silicon dioxide nanoparticles interpenetrate into the interstice between the metal oxide nanoparticles. A coating layer 3 comprising both metal oxide particles and silicon dioxide particles is formed on the printed circuit board 1 and the electronic components 2 of the PCBA 10. In some embodiments, the particle size increases as it is disposed closer to the surface of the PCBA 10. In some embodiments, the inner coating 31 may interpenetrate into the pores, gaps and other structures of the PCBA 10. The metal oxide nanoparticles of the inner coating 31 have diameters in the range of from about 5 nm to about 100 nm. The silicon dioxide nanoparticles of the outer coating 32 have diameters in the range of from about 0.1 nm to about 50 nm.

In some embodiments, the nanofilm 3 is coated onto the PCBA 10 by application and subsequent volatilization or pyrolysis of a metal oxide nanoparticle solution and a silicon dioxide nanoparticle solution, respectively. The inner coating 31 may be prepared by application and subsequent volatilization or pyrolysis of the metal oxide nanoparticle solution. The outer coating 32 may be prepared by application and subsequent volatilization or pyrolysis of the silicon dioxide nanoparticle solution.

In some embodiments, the metal oxide nanoparticle solution includes a mixture of the metal oxide nanoparticles and a first solvent. The method for preparing the metal oxide nanoparticle solution includes steps of : adding metal powders and distilled water into a serum bottle; adjusting the pH value of the mixed solution in the range of 6.5-9.5 by adding one or more of, acidic solvents such as HNO₃, HF, H₂SO₄ or HCl, neutral solvents such as IPA, acetone or alcohol, and alkaline solvents such as NaOH, KOH, or NH₄OH; and heating the mixed solution under vigorous stirring at an appropriate temperature for a period of time, for example, at about 50 °C to 150 °C for 10-20 hours to produce the metal oxide nanoparticle solution. In some embodiments, metal powders and distilled water may be mixed at a ratio in the range from 0.1 :100 to 5:100, for example, 1:100 by weight. An acid and a basic solution are added to neutralize with each other and adjust pH values. If an acid is added first, and the pH is in the acidic range after reaction, an alkaline solution may be added to neutralize the acid in excess. If the solution is too basic, an acidic solution may be added to neutralize the base in excess. The metal oxide nanoparticle solution has a concentration in the range from 0.3% to 5% by weight. The metal oxide nanoparticle solution has metal oxide nanoparticles having a size or a size distribution in the range of several to hundreds of nanometers, such as about 5 nm to about 100 nm, at room temperature. The first solvent may be selected from one of water, methanol, ethanol, and the like or any combination thereof. In some embodiments, the metal oxide nanoparticle solution is hydrophilic and transparent.

In some embodiments, the silicon dioxide nanoparticle solution includes a mixture of the silicon dioxide nanoparticles and a second solvent. The method for preparing the silicon dioxide nanoparticle solution includes steps of: adding silica powders and distilled water into a serum bottle; adjusting the pH value of the mixed solution in the range of 6.5-9.5 by adding one or more of, acidic solvents such as HNO₃, HF, H₂SO₄ or HCl, organic solvents such as IPA, acetone or alcohol, and alkaline solvents such as NaOH, KOH, or NH₄OH; adding organic solvents such as n-hexane, n-heptane, n-octane, n-dodecane, n-tetradecane, or n-hexadecane into the mixed solution; adding the metallic materials such as Fe, Cr, Mn, or Mo as the catalysts into the mixed solution; heating the mixed solution under vigorous stirring at an appropriate temperature and time, for example, at about 50 °C to 150 °C for 1-10 hours forming a two-layer mixed solution where smaller-scale silicon dioxide nanoparticles existing in the top-layer mixed solution; and extracting the top layer of the mixed solution as the second solution. This silicon dioxide nanoparticle solution has a concentration in the range from 0.3% to 5%. The silicon dioxide solution includes silicon dioxide nanoparticles having a size or a size distribution in the range of from 1 angstrom to tens of nanometers, such as 0.1 nm to 50 nm at room temperature. In the preparation of the second solution, an acid and a basic solution are added to neutralize with each other and adjust pH value. If an acid is added first, and the pH is in the acidic range after reaction, an alkaline solution may be added to neutralize the acid in excess. If the solution is too basic, an acidic solution may be added to neutralize the base in excess. In some embodiments, the solvent composition includes heptane, cetane, methyl hydrogen siloxane, the like or any combination thereof. For example, in some embodiments, the solvent includes about 70-90 wt.% (e.g., 78.6 wt. %) of heptane, 4.9-25 wt.% (e.g., 20.8 wt.%) of cetane, and methyl hydrogen siloxane. An exemplary methyl hydrogen siloxane has the following formula: 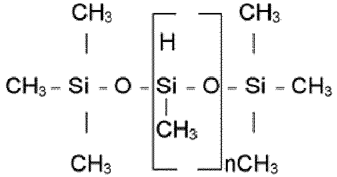 where n is in a range of 1-10 (e.g., 2-8, 2-6, 2-4, or any suitable number). The percentage of hydrogen from -SiH in methyl hydrogen siloxane may be in the range of from about 0.5 wt.% to 2.0 wt.%. The catalyst assists the surface modification of silica particles, in which some hydroxyl groups on the hydrophilic silica in the aqueous phase is grafted with organic molecules such as methyl hydrogen siloxane. The modified silica particles migrate from the aqueous phase to the organic solvent phase. In some embodiments, the silicon dioxide nanoparticle solution is transparent, hydrophobic, and low volatile. In some other embodiments, the second solvent comprises amino modified siloxane or amino modified silane. Such amino modified siloxane or silane may optionally comprise -OH groups or may react with water or moisture to generate -OH groups.

With the help of the solvent, the nanoparticles can be uniformly distributed on the PCB 1 and the electronic components 2, to avoid the agglomeration of the nanoparticles and increase the contacting area of the nanoparticles. The nanofilm 3 can be formed with high compactness, uniformity, and small thickness on the PCBA 10.

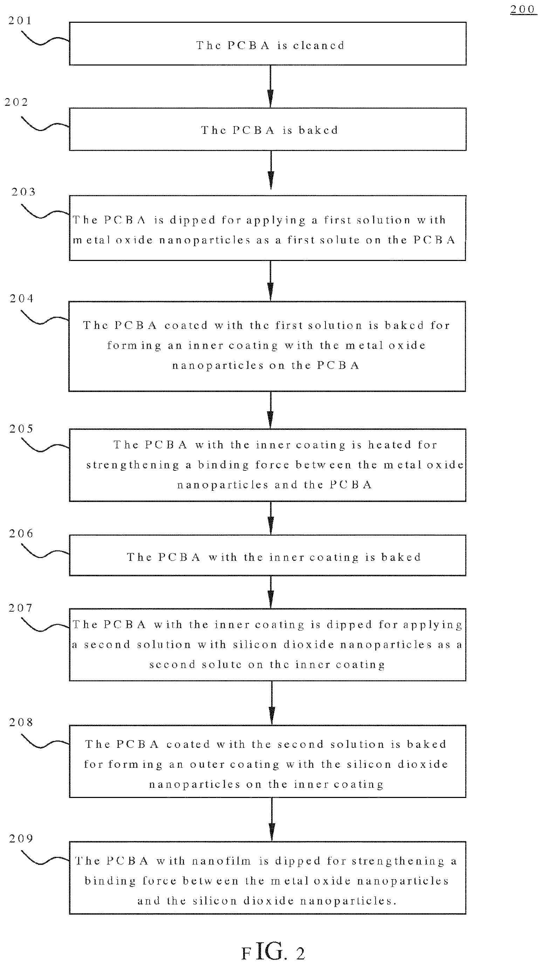

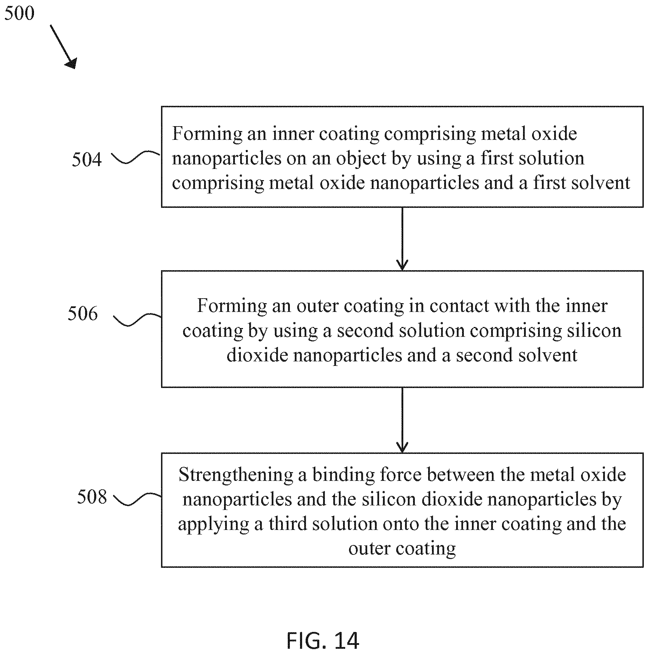

Referring to FIGS. 2 and 14, exemplary methods 200 and 500 are illustrated. Exemplary method 200 provides details of exemplary method 500. Exemplary method 500 comprises step 504 of forming an inner coating 31 comprising metal oxide nanoparticles on an object by using a first solution comprising metal oxide nanoparticles and a first solvent, step 506 of forming an outer coating 32 in contact with the inner coating 31 by using a second solution comprising silicon dioxide nanoparticles and a second solvent; and step 508 of strengthening a binding force between the metal oxide nanoparticles and the silicon dioxide nanoparticles by applying a third solution onto the inner coating and the outer coating. In some embodiments, step 504 of FIG. 14 may include steps 203 and 204 of FIG. 2. Steps 506 of FIG. 14 may include steps of 207 and 208.

FIG. 2 illustrates an exemplary method 200 for coating the PCBA 10 with metal oxide nanoparticles and silicon dioxide nanoparticles, according to some embodiments. The PCBA 10 may be placed on a loader (not shown) to execute later steps.

At step 201, the PCBA 10 is cleaned for removing soldering flux residue formed in manufacturing process. In some embodiments, the PCBA 10 is cleaned with pure water at a temperature in the range of from about 40 °C to about 60 °C for 10-30 minutes in an ultrasonic cleaning machine.

At step 202, the PCBA 10 is baked, that can dry the PCBA 10 and expose pores, gaps and other structures of the PCBA 10. In some embodiments, the PCBA 10 is baked at a temperature in the range of from about 50 °C to about 150 °C for a period of time in the range of 10-30 minutes in a baking equipment (not shown).

At step 203, a first solution including metal oxide nanoparticles as a first solute and a first solvent is applied on the PCBA 10. In some embodiments, the PCBA 10 may be dipped in, sprayed with or brushed with the first solution or other possible ways for applying the first solution on the PCBA 10. The metal oxide nanoparticles have diameters in the range of about 5 nm and about 100 nm. In some embodiments, the concentration range of the first solution is from 0.3 wt. % to 5 wt.%.

At step 204, the PCBA 10 with the first solution distributed thereon is baked for removing the solvent and leaving the metal oxide nanoparticles on the PCBA 10 to form an inner coating 31 by at least one of volatilization and pyrolysis of a first solvent of the first solution. In some embodiments, the PCBA 10 with the first solution is baked at a temperature in a range of from about 50 °C to about 150 °C for a period of time in a range of 5-30 minutes in a baking equipment (not shown). This temperature and period of time are referred as the first temperature and the first period of time. The first solvent is one of water, methanol or ethanol or any combination thereof, which can help the metal oxide nanoparticles more uniformly distributed on the PCBA 10. The PCBA 10 with the inner coating 31 is unloaded from the loader.

At step 205, the PCBA 10 with the inner coating 31 is heated for strengthening a binding force between the metal oxide nanoparticles and the PCBA. In some embodiments, the PCBA 10 coated with the inner coating 31 is heated at a temperature in a range from about 25 °C to 100 °C for a period of time in a range of 2-72 hours. This temperature and period of time are referred as the second temperature and the second period of time. Other ways the skilled artisan may use for strengthening the binding force between the metal oxide nanoparticles and the PCBA 10 should fall in the present disclosure. After being heated, the PCBA 10 with the inner coating 31 is placed in a loader (not shown).

At step 206, the PCBA 10 with the inner coating 31 is baked. The baking process can expose pores, gaps, and other structures of the inner coating 31. In some embodiments, the PCBA 10 with the inner coating 31 is baked at a temperature in a range of from about 50 °C to about 150 °C for a suitable period of time in a range of 10-30 minutes in a baking equipment (not shown). This temperature and period of time are referred as the third temperature and the third period of time. In some embodiments, after the binding force between the metal oxide nanoparticles and the PCBA 10 is strengthened, before the PCBA 10 with the inner coating 31 is baked, a step of checking the appearance of the PCBA 10 coated with the inner coating 31 and cleaning the PCBA with the inner coating 31 is included.

At step 207, a second solution with silicon dioxide nanoparticles as a second solute is applied on the inner coating 31. The second solution includes the silicon dioxide nanoparticles and a second solvent. The silicon dioxide nanoparticles have diameters in the range of from about 0.1 nm to about 50 nm. In some embodiments, the PCBA 10 coated with the metal oxide nanoparticles may be dipped in, sprayed with, or brushed with the second solution or subjected to other ways for applying the second solution on the inner coating 31. In some embodiments, the second solvent of the second solution includes heptane, cetane, methyl hydrogen siloxane, or a combination thereof. In some other embodiments, the second solvent comprises amino modified siloxane or amino modified silane. The second solvent can help the silicon dioxide nanoparticles more uniformly distributed on the inner coating 31.

At step 208, the PCBA 10 with the second solution is baked for removing the second solvent and leaving the silicon dioxide nanoparticles on the inner coating 31 as an outer coating 32. In some embodiments, the PCBA 10 with the second solution is baked at a temperature in a range of from about 50 °C to about 150 °C for a suitable period in a range of 10-30 minutes in a baking equipment (not shown). This temperature and period of time are also referred as the fourth temperature and the fourth period of time.

At step 209, the PCBA 10 with nanofilm 3 is dipped for strengthening a binding force between the metal oxide nanoparticles and silicon dioxide nanoparticles. In some embodiments, the PCBA 10 coated with the nanofilm 3 is dipped into a third solution (solvent or mixture) for about 10-30 seconds. The third solution may be pure water, an alcohol such as ethanol, or any combination thereof. In some embodiments, the third solution or solvent is pure water (deionized water or distilled water). The third solution such as water may be in a suitable temperature in a range of from about 50°C to about 80°C. By using the third solution or solvent such as water can increase hydroxyl group dissociation for increasing the chemical reaction of covalent bonds in the interfaces, for example, between inner coating 31 and outer coating 32, and/or between the inner coating 31 and the PCBA 10. The third solution may increase concentration of hydroxyl groups on the surfaces or interfaces of inner coating 31, outer coating 32, and/or surface of the PCBA 10, and thus promote formation of covalent bonds at the interfaces through chemical reactions of hydroxyl groups. In some embodiments, silicon dioxide nanoparticles comprises methyl hydrogen siloxane grafted on the surface. When water (such as warm or hot water) is added, chemical group -Si-H is converted into -Si-OH, which will reach with -Ti-OH on the metal oxide particles to form interfacial -Si-O-Ti bonds. The chemical groups -Si-OH and -Ti-OH may also make the nanoparticles fused or bonded together in the inner coating and the outer coating, respectively. In some other embodiments, silicon dioxide nanoparticles comprises amino modified siloxane or amino modified silane. Such amino modified siloxane or silane may optionally comprise -OH groups or may react with water or moisture to generate -OH groups. Similarly, the chemical groups -Si-OH reacts with -Si-OH or -Ti-OH to form -Si-O -Si - or -Si-O-Ti- bonds, respectively.

In other ways the skilled artisan use, the PCBA may be sprayed with or brushed with the third solution or solvent such as pure water. Any other suitable technique may be used for applying the third solvent such as distilled water onto the PCBA 10 with nanofilm 3. Then the appearance and the function of the PCBA 10 with nanofilm 3 are checked.

In some embodiments, the surface to be coated (or substrate) on the object or a device such as PCBA contains metal. First, covalent bonds between metal and the metal nanoparticles are formed in the interface between the metallic surface and the inner coating. Such bonds may be in the form of -M₁-O-M₂-, where M₁ is the metal from the substrate and M₂ is the metal in metal oxide nanoparticles. Second, covalent bonds between the metal nanoparticles and the silicon dioxide nanoparticles are formed in the interface between inner coating 31 and outer coating 32. Such bonds may be in the form of -Si-O-M₂- . In addition to superhydrophobic properties, the interfacial bonding improves the performance of the device.

In some embodiments, one or more components of electronic device 100 may not need to be covered by nanofilm 3. For example, when the PCBA 10 includes a speaker, a microphone, a switch or other components, the speaker, the microphone, or the switch needs to be exposed. Thus, when applying the first solution and the second solution on the PCBA 10, these components need to be masked. In some embodiments, the microphone and the switch may be masked before the PCBA 10 is cleaned in step 201 because a diaphragm of the microphone and the switch need to be kept from touching water or other liquid. In some embodiments, the switch may be masked before the second solution applied on the inner coating in step 207 because the second solution with the silicon dioxide nanoparticles will affect the function of the switch. For example, the switch may be masked before the second solution applied on the inner coating 31 in step 207 and after the binding force between the metal oxide nanoparticles and the PCBA is strengthened in step 205. As another example, the switch may be masked before PCBA 10 with the inner coating 31 is baked in step 206 and after the binding force between the metal oxide nanoparticles and the PCBA is strengthened in step 205. A masking material on these components may be removed after the outer coating 32 is formed.

In the present disclosure, all the temperature values are in Celsius scale. The percentages in the formulations are in weight percent (wt.%) even though volume percentages in the similar ranges are also acceptable.

In some embodiments, the silicon dioxide nanoparticles may be silica particles, which are amorphous and hydrophobic. The silica particles (e.g., fumed silica) are obtained from a supplier, without any chemical modification. These particles provide desirable hydrophobilicity in a coated surface. The silica particles may be chemically modified in some other embodiments.

Silica particles used may have some hydroxyl (-OH) groups on the surface. These hydroxyl groups may react with a hydroxyl group on a surface of a substrate and/or metal oxide nanoparticles, and promote formation of covalent bonds to improve coating adhesion.

In the solution or suspension containing nanoparticles, a surfactant or dispersant may be used in some embodiments.

A thickness of nanofilm 3 is less than 200 nm in some embodiments. For example, the coating thickness may be in the range of from 5 nm to 100 nm, from 10 nm to 20 nm, or in other suitable ranges depending on usage of the electronic device 100.

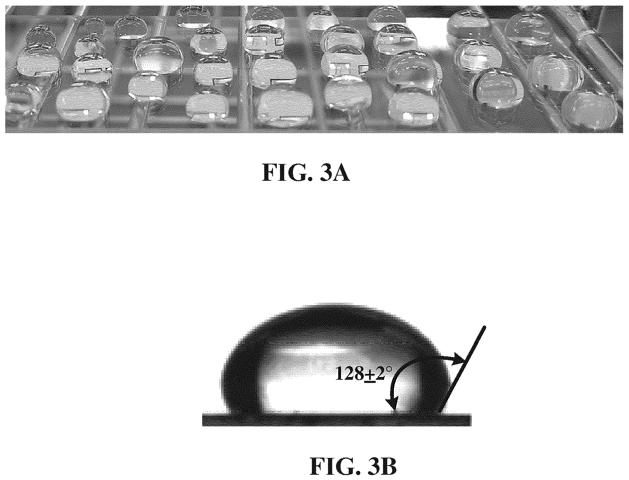

FIG. 3A is a picture of water droplets formed on a glass substrate coated with a nanofilm consistent with embodiments of the present disclosure. As shown in FIG. 3A, because of the superhydrophobic effect of the nanofilm 3, the water on the glass substrate coated with the nanofilm is dispersed to form tiny water droplets. FIG. 3B is a close-look of a tiny water droplet. A contact angle θ between the water droplet and the glass substrate coated with the nanofilm is 128±2°. Generally, 0 ≥ 90°, or 0 ≥ 110°, or 0 ≥ 130°, or 150 ≥ θ ≥ 110°, or 150 ≥ θ ≥ 90°.

### EXAMPLES

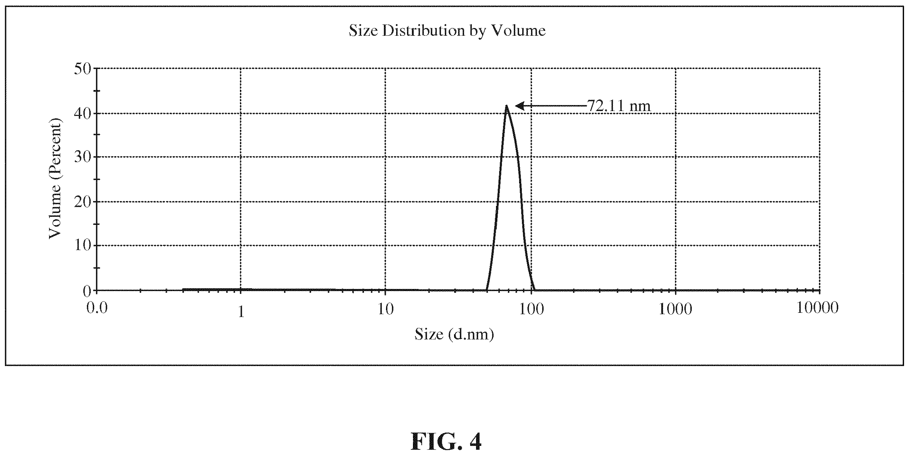

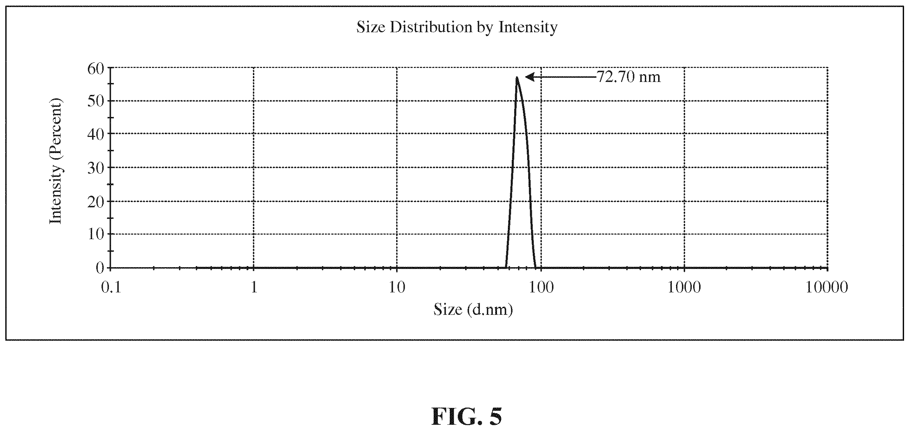

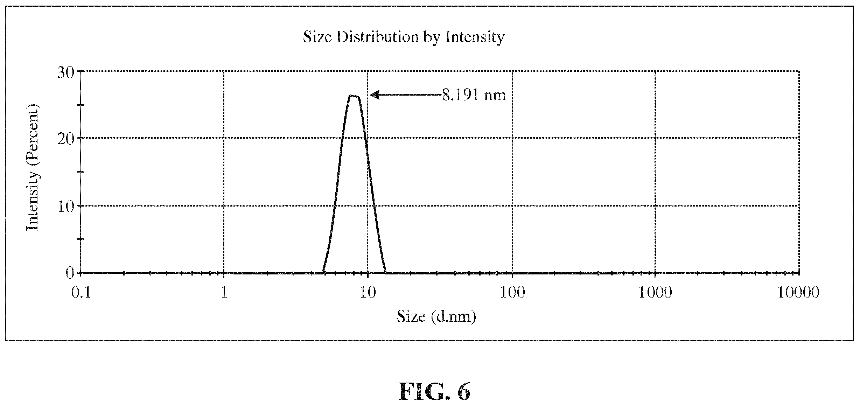

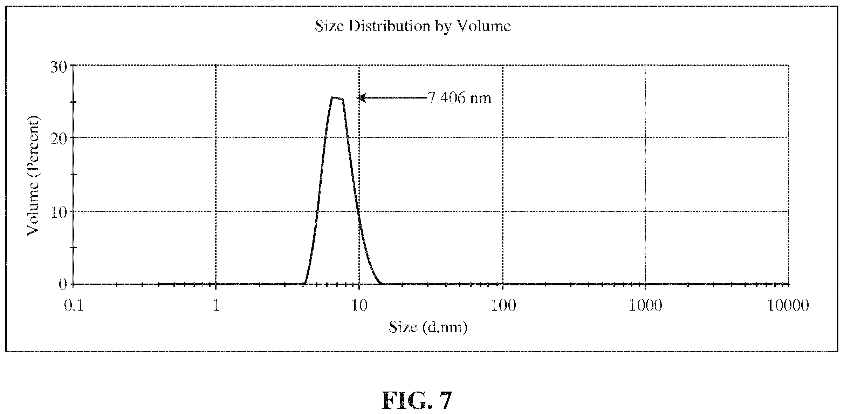

Nanofilm coatings may be formed using the following two solutions (or mixtures or suspensions). A first solution includes TiO₂ nanoparticles having a particle size in the range from about 5 nm to about 100 nm dispersed in pure water as the first solvent. The content of TiO₂ nanoparticles in the first solution is in the range from about 0.8 wt.% to about 1.5 wt.%. The first solution has a density of 1.01 g/cm³. Exemplary particle size distribution data of the first solution of four preparation batches are shown in FIGS. 4-7. FIG. 4 shows that all TiO₂ nanoparticles in a first solution have an average diameter of about 72.11 nm at room temperature. FIG. 5 shows that all TiO₂ nanoparticles in a first solution have an average diameter of 72.70 nm at room temperature. FIG. 6 shows that all TiO₂ nanoparticles in a first solution have a diameter of 8.191 nm at room temperature. FIG. 7 shows that all TiO₂ nanoparticles in a first solution have an average diameter of 7.406 nm at room temperature. The TiO₂ nanoparticles have a very narrow particle size distribution as shown in FIGS. 4-7, with standard deviation with +/- 5 nm, 10 nm or 20 nm.

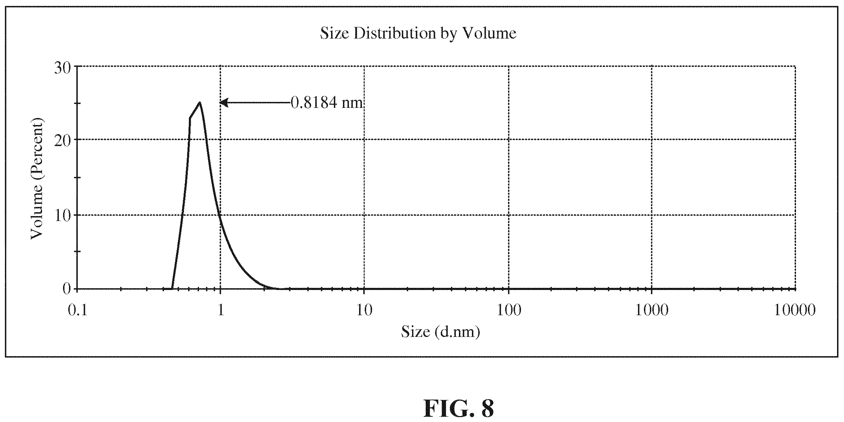

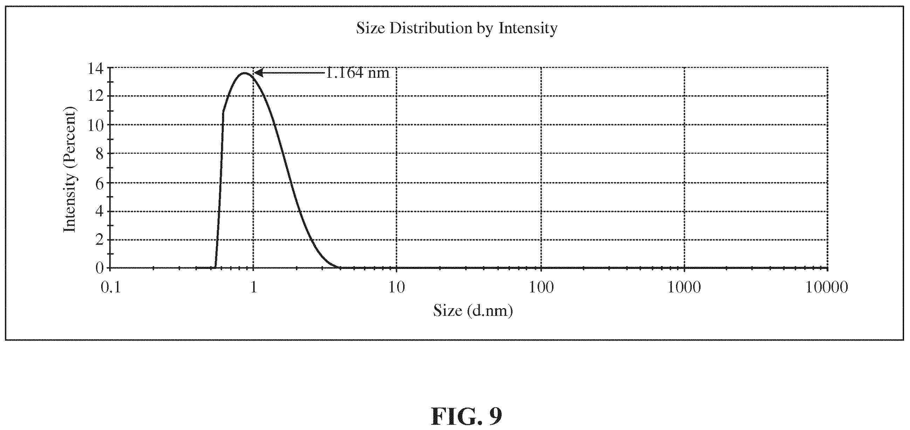

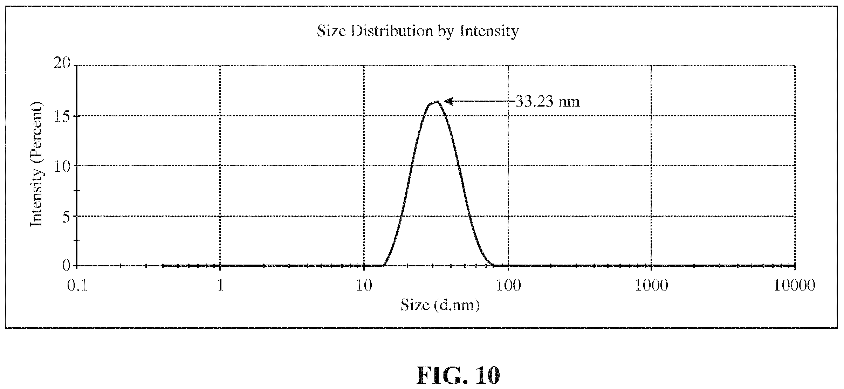

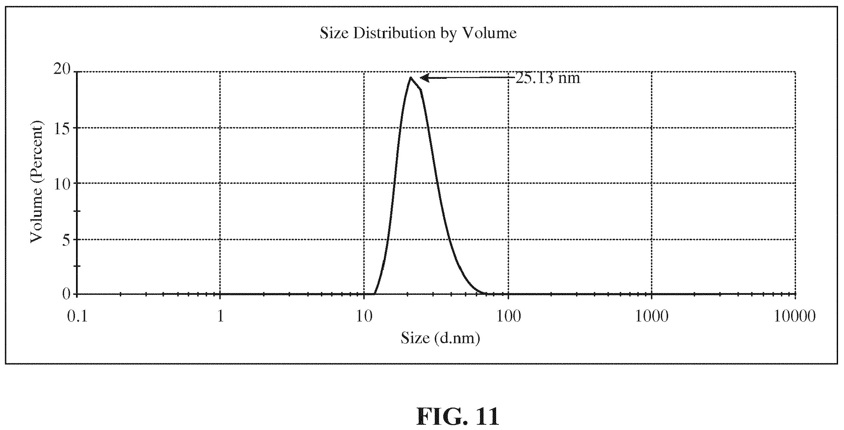

A second solution includes SiO₂ nanoparticles having a particle size in the range from about 5 nm to about 100 nm dispersed in heptane and hexadecane. The second solution may also contain methyl hydrogen polysiloxane (about 0.1-5 wt.%). The content of SiO₂ nanoparticles in the second solution is in the range from about 0.1 wt.% to about 5 wt.%. The second solution has a density of 0.774 g/cm³. Exemplary particle size distribution data of the second solution of four preparation batches are shown in FIGS. 8-11. FIG. 8 shows that all TiO₂ nanoparticles in a second solution have an average diameter of 0.8184 nm at room temperature. FIG. 9 shows that all TiO₂ nanoparticles in a second solution have an average diameter of 1.164 nm at room temperature. FIG. 10 shows that all TiO₂ nanoparticles in a second solution have an average diameter of 33.23 nm at room temperature. FIG. 11 shows that all TiO₂ nanoparticles in a second solution have an average diameter of 25.13 nm at room temperature. The SiO₂ nanoparticles have a very narrow particle size distribution as shown in FIGS. 8-11, with standard deviation with +/- 5 nm, 10 nm or 20 nm.

For example, in one exemplary process, a PCBA was cleaned with a solvent and dried at 60 °C for 10 minutes. The cleaned PCBA was immersed in the first solution for about 5-10 seconds, followed by a baking at 150 °C for 5 minutes and at 50 °C for 8 hours. After preheated at 80 °C for 10 minutes, the PCBA was immersed in the second solution for 5-10 seconds. The PCBA was then baked at 100 °C for 20 minutes.

Hereinafter, the performance of a PCBA with nanofilm in some embodiments of the present disclosure will be explained with reference to test results.

### Corrosion-resistance test I

In this test, a PCBA with a nanofilm is compared with a PCBA with a conventional film formed by vapor deposition of the prior art technology. The thickness of the film formed by vapor deposition is difficult to control. It is found that as the thickness of the film by vapor deposition increase, its protective effect is improved, but the performance of the PCBA becomes worse. In this test, a thickness range of the film formed by vapor deposition is between 3 µm to 5 µm. The test procedures are described as following: drip an artificial sweat on each electronic component of both test PCBA products at a rate of 0.05 mL every 5 min for one hour, and put both the test products into the 40 °C oven to dry the electronic components for 4 hours. The artificial sweat comprises NaCl (10%), lactic acid (1%), disodium hydrogen phosphate (1%), and histidine .HCl (0.15%) and distilled water. Each of the above procedures is repeated twice a day. After completing the above-mentioned procedures, the electronic components are tested every day. The above testing steps are repeated until all of the electronic components of the both test PCBA products are not working/functioning. The test result is shown in Table 1, a corrosion rate of the PCBA with a film formed by vapor deposition is faster than that of the PCBA with the nanofilm consistent with the disclosure of the present disclosure. As a result, the nanofilm in this embodiment has better corrosion-resistance property.

**Table 1**

| Test sample | Number of Non-Functioning Components | | | | | | | |
|---|---|---|---|---|---|---|---|---|
| | Day1 | Day2 | Day3 | Day4 | Day5 | Day6 | Day7 | Day8 |
| PCBA coated with nanofilm | 0 pcs | 2 pcs | 2 pcs | 4 pcs | 4 pcs | 4 pcs | 7 pcs | 8 pcs |
| PCBA coated with a film formed by vapor deposition | 1 pcs | 2 pcs | 3 pcs | 4 pcs | 5 pcs | | | |

### Corrosion-resisting test II

Another corrosion-resisting test is used to test the chemical durability of the nanofilm. In this test, a PCBA coated with a nanofilm connects to a plug thereon. The test procedure is described as following: the PCBA coated with the nanofilm and the plug are dipped into the artificial sweat and then taken out; the plug is connected with a receptacle for charging for one hour. The PCBA coated with the nanofilm and the plug are dipped in the artificial sweat again after charging. The dipping and charging actions are repeated for 200 times. The charging current, charging voltage, and charging indicator are observed until the charging action fails. The test result after 200 cycles is shown in Table 2, the PCBA coated with nanofilm and the plug are not affected by sweat and can be used in a range of criteria.

**Table 2**

| | | | |
|---|---|---|---|
| Function check item | Charging voltage | Charging current | Indicator light |
| Result | Under spec | Under spec | normal |

### Water proof test I

Two earphones are used to test a waterproof function of a PCBA coated with a nanofilm of the present disclosure. Each of the earphones has a PCBA with a nanofilm. The test procedure is described as following: put the earphones under the water and record the play time under the water until the earphones stop working. The test result is shown in Table 3, the average working time under the water is 207.5 min. The waterproof function of the PCBA with the nanofilm is improved with an acceptable protection of electronic components of the earphones.

**Table 3**

| Sample No. | Time (min) | Avg. (min) |
|---|---|---|
| Sample #1 | 199 | 207.5 |
| Sample #2 | 216 | |

### Water proof test II

In this test, a PCBA coated with a nanofilm is connected with a battery pack. The test procedure is described as following: put the battery pack and the PCBA with the nanofilm under the water for 30 min and observe the working condition of the battery pack. The test result is shown in Table 4 below. The battery pack connecting with the PCBA with nanofilm can work normally under the water.

**Table 4**

| Check Item | Visual Inspection of Battery Module | Electric function Test | Reliability Test |
|---|---|---|---|
| Battery Pack Samples | PASS | PASS | PASS |

### Resistance measured test

In order to confirm whether the nanofilm affects the surface resistance of the PCBA or not, the test measures the surface resistance of a PCBA before and after it is coated with a nanofilm. The test result is shown in Table 5 and confirms that the nanofilm substantially has no effect on the surface resistance of the PCBA. The difference of the surface resistance of the PCBA before and after it is coated with the nanofilm is within 1 %.

**Table 5**

| Resistance (Avg.) | | |
|---|---|---|
| Before | 82.103 Ω | 92.413 Ω |
| After | 82.356 Ω | 92.473 Ω |
| Difference | 0.253 Ω | 0.06 Ω |
| | (0.31%) | (0.06%) |

### Current measurement test

In order to confirm whether the nanofilm affects the surface current of the PCBA or not, the test measures the surface currents of four test points in a PCBA before and after it is coated with a nanofilm. The test result is shown in Table 6. The nanofilm substantially has no effect on the surface current of the PCBA. The difference of the surface currents of the PCBA before and after it is coated with the nanofilm is within 1%.

**Table 6**

| Current | | | | |
|---|---|---|---|---|
| Test Point | 1 | 2 | 3 | 4 |
| Before | 59.047 µA | 210.299 µA | 218.795 µA | 15.159 mA |
| After | 59.505 µA | 209.821 µA | 219.1 µA | 15.197 mA |
| Difference | 0.458 µA | -0.478 µA | 0.305 µA | 0.038 mA |
| | (0.78%) | (-0.23%) | (0.14%) | (0.25%) |

In order to confirm whether the binding force between the metal oxide nanoparticles and silicon dioxide nanoparticles can be strengthened by dipping in pure water or not, a first test measures the current performance of different samples under deionized water (DI water). The test procedure is described as following: prepare ten samples, each of samples is a PCBA coated with the nanofilm. Five samples proceed step 209 which is dipped in warm pure water at a temperature of 50°C to 80°C for about 10-30 seconds. And then, all of samples dip in the DI water and supply 15V/70mA by power supply. Use the multimeter to record the work time and the current until the current over the 70 mA. The test results are shown in Table 7. The PCBA coated with the nanofilm and proceed the procedure 209 has better waterproof performance than those without proceed the procedure 209. Compared to the samples without step 209, when the second solvent contained methyl hydrogen siloxane, the samples with step 209 improved the work time by 1-2 times. When the second solvent contained amino modified siloxane, the samples with step 209 improved the work time by 2-3 times.

**Table 7**

| Procedure | Sample No. | Time (min) | Avg. (min) |
|---|---|---|---|
| Without dipped in the pure water (without step 209) | 1 | 9m 27s | 12m 06s |
| | 2 | 11m 43s | |
| | 3 | 12m 15s | |
| | 4 | 12m 12s | |
| | 5 | 14m 54s | |
| With dipped in the pure water (step 209) | 1 | 33m 56s | 34m 09s |
| | 2 | 35m 52s | |
| | 3 | 44m 57s | |
| | 4 | 30m 46s | |
| | 5 | 25m 15s | |

A second test measures the current performance of different samples under artificial sweat: The test procedure is described as following: prepare four samples, each of samples is a resistance (10 ohm) coated with the nanofilm. Two of samples proceed step 209 which is dipped in the pure water for about 10-30 seconds. And then, all of samples dip in the artificial sweat and supply 4.2V/100mA by power supply. Use the multimeter to record the work time and the current until the current over the 100 mA. The test result is shown in Table 8. The resistance coated with the nanofilm and proceed the procedure 209 has better corrosion-resisting performance than those without proceed the procedure 209.

**Table 8**

| Procedure | Sample No. | Time (min) | Avg. (min) |
|---|---|---|---|
| Without dipped in the pure water (without step 209) | 1 | 3m 01s | 3m 27s |
| | 2 | 3m 52s | |
| With dipped in the pure water (step 209) | 1 | 10m 01s | 8m 40s |
| | 2 | 7m 19s | |

Binding force between the metal oxide nanoparticles and silicon dioxide nanoparticles after dipped in pure water: The PCBA 10 with nanofilm 3 is dipped for strengthening a binding force between the metal oxide nanoparticles and silicon dioxide nanoparticles (step 209). In some embodiments, the PCBA 10 coated with the nanofilm 3 is dipped in pure water for about 10-30 seconds. By using pure water can increase hydroxyl group dissociation for increasing the chemical reaction of covalent bonds. Other ways the skilled artisan may be sprayed with or brushed with the pure water

The process of coating a nanofilm consistent with embodiments of the present disclosure can be applied in other devices by a skilled artisan. For example, when a cable is connected with the PCBA, the cable and the PCBA are coated simultaneously. After the coating process, the cable has a good waterproof characteristic, a good corrosion resistance, and a smaller friction. The temperatures and time periods of the above cleaning, baking and heating processes in coating a nanofilm may be modified in accommodation with different devices.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments are chosen and described in order to best explain the principles of the invention and its practical applications, to thereby enable others skilled in the art to best utilize the invention and various embodiments with various modifications as are suited to the particular use contemplated.

In some embodiments, the present disclosure provides a method for coating a device. The method comprises the following steps: cleaning the device; baking the device; applying a first solution having metal oxide nanoparticles as a first solute on the device, the metal oxide nanoparticles having diameters in the range of about 5 nm to about 100 nm; forming an inner coating on the device with the metal oxide nanoparticles by at least one of volatilization or pyrolysis of a first solvent of the first solution; strengthening a binding force between the metal oxide nanoparticles and the device; baking the device coated with the inner coating; applying a second solution having silicon dioxide nanoparticles as a second solute on the inner coating, the silicon dioxide nanoparticles having diameters in the range of about 0.1 nm and about 50 nm; forming an outer coating with the silicon dioxide nanoparticles on the inner coating by at least one of volatilization or pyrolysis of a second solvent of the second solution; and strengthening the bonding between metal oxide nanoparticles and silica nanoparticles.

In some embodiments, the first solution is applied on the device by dipping, spraying, or brushing. The second solution is applied on the device by dipping, spraying, or brushing. In some embodiments, one of volatilization and pyrolysis of the first solvent of the first solution includes a baking treatment that is applied to the device coated with the first solution. One of volatilization and pyrolysis of the second solvent of the second solution includes a baking treatment that is applied to the device coated with the second solution. The device may be cleaned in an ultrasonic cleaning machine.

In some embodiments, the method further includes a step of checking the appearance of the device coated with the inner coating and cleaning the device coated with the inner coating after strengthening a binding force between the metal oxide nanoparticles and the device and before baking the device with the inner coating. The binding force between the metal oxide nanoparticles and the device may be strengthened by a heat treatment.

In some embodiments, a concentration of metal oxide nanoparticles in the first solution is about 0.3-5 wt. %. A concentration of silicon dioxide nanoparticles in the second solution is about 0.3-5 wt. %. The first solvent may include one of water, methanol, or ethanol, or a combination thereof. The second solvent may include heptane, cetane, methyl hydrogen siloxane, or a combination thereof.

In some embodiments, the method further includes a step of masking one or more portions of the device before cleaning the device and a step of removing a masking material on the portions of the device after the outer coating is formed. The method may also include a step of masking one or more portions of the device before the step of applying the first solution on the device and the step of baking the device, and a step of removing a masking material on the portions of the device after the outer coating is formed. The method may also include a step of masking one or more portions of the device before the second solution is applied to the device coated with the inner coating and after strengthening a binding force between the metal oxide nanoparticles and the device, and a step of removing a masking material on the portions of the device after the outer coating is formed.

In some embodiments, the present disclosure provides a method for coating a printed circuit board assembly (PCBA), including: cleaning the PCBA; baking the PCBA at about 50 °C to 150 °C for 10-30 minutes; applying a first solution having metal oxide nanoparticles as a first solute on the PCBA, the metal oxide nanoparticles having diameters in the range of about 5 nm and about 100 nm; baking the PCBA coated with the first solution at about 50 °C to 150 °C for 5-30 minutes for forming an inner coating on the PCBA with the metal oxide nanoparticles; strengthening a binding force between the metal oxide nanoparticles and the PCBA; baking the PCBA coated with the inner coating at about 50 °C to 150 °C for 10-30 minutes; applying a second solution having silicon dioxide nanoparticles as a second solute on the inner coating, the silicon dioxide nanoparticles having diameters in the range of about 0.1 nm and about 50 nm; baking the PCBA coated with the second solution at about 50 °C to 150 °C for 10-30 minutes for forming an outer coating on the inner coating with the silicon dioxide nanoparticles; and strengthening the bonding between metal oxide nanoparticles and silica nanoparticles.

In some embodiments, the PCBA is cleaned with pure water at about 40 °C to 60 °C for 10-30 minutes in an ultrasonic cleaning machine. The method may further include a step of checking the appearance of the PCBA coated with the inner coating and cleaning the PCBA coated with the inner coating after strengthening the binding force between the metal oxide nanoparticles and the PCBA and before baking the PCBA with the inner coating. The binding force between the metal oxide nanoparticles and the PCBA can be strengthened by a heat treatment at about 25 °C to 100 °C for 2 hours to 72 hours. A concentration of the metal oxide nanoparticles in the first solution is about 0.3 wt.%-5 wt.%. A concentration of the silicon dioxide nanoparticles in the second solution is about 0.3 wt.%-5 wt.%. The first solvent is one of water, methanol or ethanol, or a combination thereof. The second solvent comprises heptane, cetane, methyl hydrogen siloxane, or a combination thereof. In some other embodiment, the second solvent may comprises amino modified siloxane or silane.

In some embodiments, the method further includes a step of masking one or more portions of the PCBA before cleaning the PCBA and a step of removing a masking material on the portions of the PCBA after the outer coating is formed. The method may further include a step of masking one or more portions of the PCBA before the step of applying the first solution on the device and the step of baking the PCBA and a step of removing a masking material on the portions of the PCBA after the outer coating is formed. The method may further include a step of masking one or more portions of the PCBA before the second solution is applied to the PCBA coated with the inner coating and after strengthening a binding force between the metal oxide nanoparticles and the PCBA, and a step of removing a masking material on the portions of the PCBA after the outer coating is formed.

In another aspect, the present disclosure also provides a device including: a printed circuit board assembly (PCBA), and a nanofilm on the PCBA. The PCBA includes a printed circuit board and one or more electronic components mounted in the printed circuit board. The nanofilm including an inner coating in contact with the printed circuit board assembly and an outer coating in contact with the inner coating. The inner coating includes metal oxide nanoparticles having a particle diameter in a range of 5 nm to 100 nm. The outer coating includes silicon dioxide nanoparticles having a particle diameter in a range of 0.1 nm to 50 nm. The two types of nanoparticles are covalently bonded in the interface(s) between the inner and outer coatings.

In some embodiments, the nanofilm is formed by volatilization or pyrolysis of a metal oxide nanoparticle solution and a silicon dioxide nanoparticle solution. The metal oxide nanoparticle solution has a concentration range between 0.3 wt. % to 5 wt. %. The silicon dioxide nanoparticle solution has a concentration range between 0.3 wt. % to 5 wt. %. The electronic components may include a resistor, a capacitor, an inductor, a transistor, a diode, a connector, a speaker, a microphone or any other electronic component which is capable of being mounted on the printed circuit board. The printed circuit board is made from a FR-4 composite material in some embodiments.

Although the present disclosure uses a PCBA as example, other substrates, such as metal, glass, plastic substrates, or other electronic devices can be coated with the nanofilm.

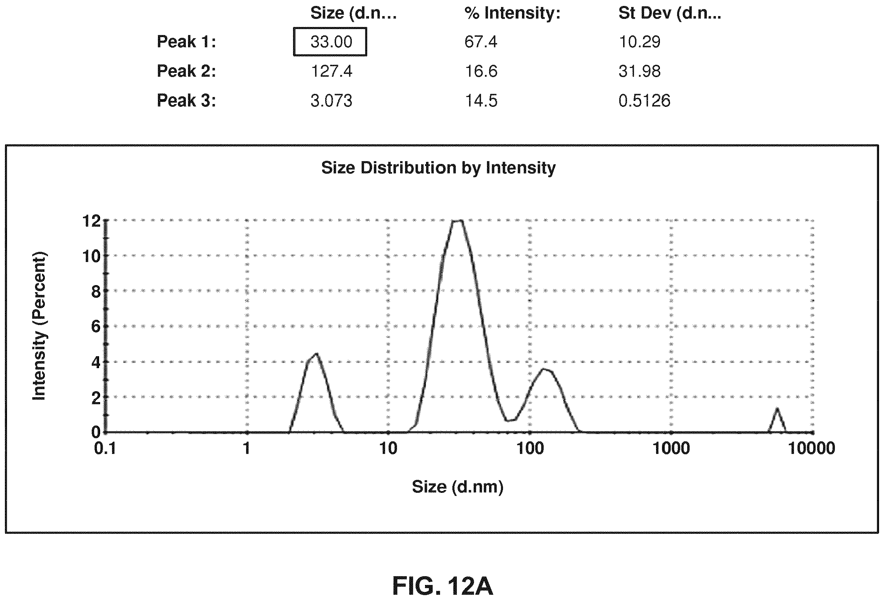

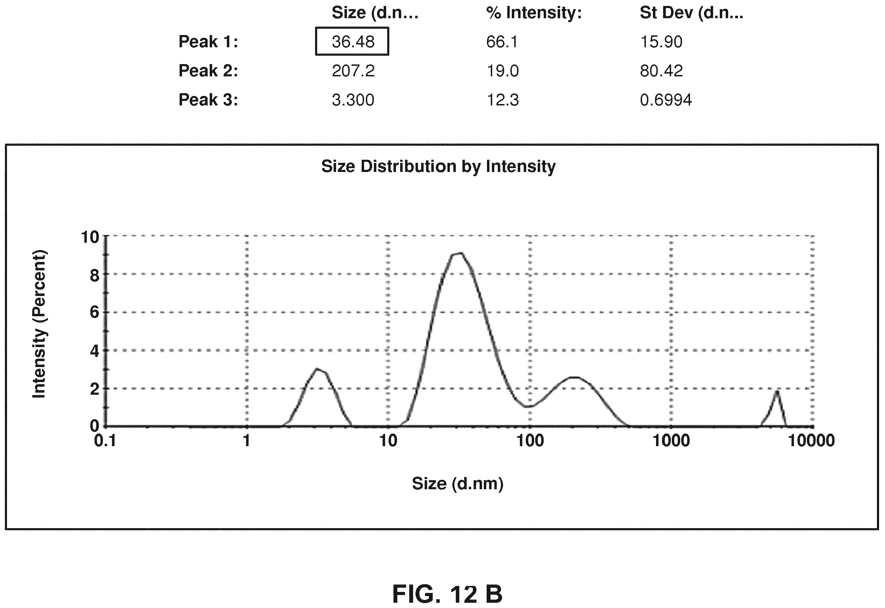

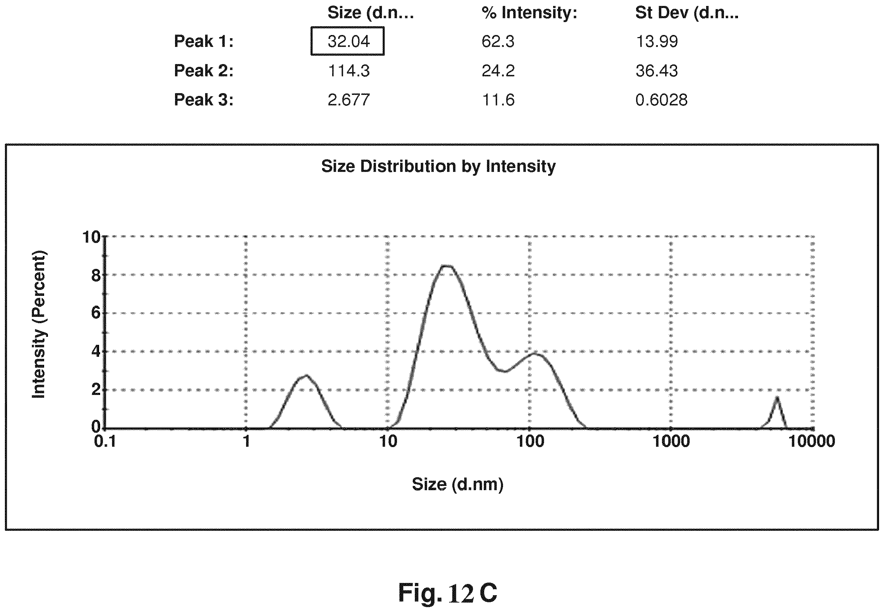

In some embodiments, the first nanofilm may include TiO₂ nanoparticles and the second nanofilm may include SiO₂ nanoparticles. Test results of the particle sizes are shown in the following figures. FIGS. 12A-12C show three measurement results of particle size distribution of TiO₂ nanoparticles by a dynamic light scattering (DLS) method. The majority of particle size (diameter) of TiO₂ nanoparticles is in the range of from about 32 nm to 36 nm. A second highest particle-size peak is located at about 110 nm to 220 nm.

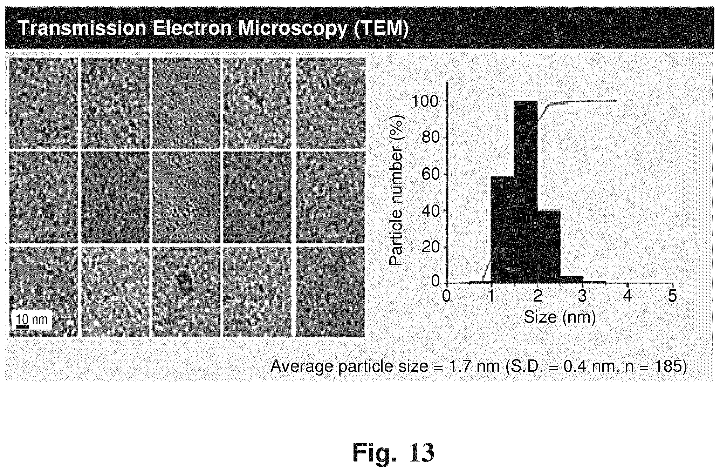

FIG. 13 shows transmission electron microscopy (TEM) images of SiO₂ nanoparticles and a particle size distribution diagram. The particle size (diameter) of the SiO₂ nanoparticle is in the range from 1 nm to 2.5 nm (average size 1.7 nm ± 0.4 nm).

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with a true scope and spirit of the invention being indicated by the following claims.

It will be appreciated that the present disclosure is not limited to the exact construction that has been described above and illustrated in the accompanying drawings, and that various modifications and changes can be made without departing from the scope thereof. It is intended that the scope of the invention only be limited by the appended claims.

## Claims

1. A method, comprising steps of:
forming an inner coating on an object, wherein the step of forming the inner coating comprising
applying a first solution onto the object, the first solution comprising metal oxide nanoparticles and a first solvent,
removing the first solvent to form the inner coating with the metal oxide nanoparticles on the object;
forming an outer coating in contact with the inner coating, where the step of forming the outer coating comprising
applying a second solution onto the object, the second solution comprising silicon dioxide nanoparticles and a second solvent,
removing the second solvent to form the outer coating with the silicon dioxide nanoparticles; and
strengthening a binding force between the metal oxide nanoparticles and the silicon dioxide nanoparticles.

2. The method of claim 1, wherein the step of strengthening the binding force between the metal oxide nanoparticles and the silicon dioxide nanoparticles comprises applying a third solution to the inner coating and the outer coating.

3. The method of claim 2, wherein the third solution is water, ethanol, or any combination thereof.

4. The method of claim 2, wherein the third solution is applied by at least one technique selected from the group consisting of dipping, spraying and brushing for a period of time in a range of from about 10 seconds to about 30 seconds.

5. The method of claim 1, further comprising:
masking one or more portions of the object with a masking material before applying the first solution onto the object; and
removing the masking material after the outer coating is formed to expose the one or more portions of the object.

6. The method of claim 1, further comprising
masking one or more portions of the inner coating with a masking material before applying the second solution onto the object; and
removing the masking material from the one or more portions of the inner coating after the outer coating is formed to expose one or more portions of the inner coating.

7. The method of claim 1, wherein the first solvent is removed by heating the object at a first temperature in a range of from about 50 °C to 150 °C for a first period of time in a range of from about 5 minutes to about 30 minutes.

8. The method of claim 7, further comprising
baking the object coated with the inner coating at a second temperature for a second period of time after the inner coating is formed, the first temperature being higher than the second temperature, and the first period of time being shorter than the second period of time.

9. The method of claim 8, wherein the second temperature is in a range of from about 25 °C to about 100 °C, and the second period of time is a range of from about 2 hours to about 72 hours.

10. The method of claim 8, further comprising
baking the object coated with the inner coating at a third temperature for a third period of time after baking the object at the second temperature for the second period of time, the third temperature being higher than the second temperature, and the third period of time being shorter than the second period of time.

11. The method of claim 10, wherein the second temperature is in a range of from about 50 °C to about 150 °C, and the second period of time is a range of from about 10 minutes to about 30 minutes.

12. The method of claim 1, wherein the second solvent is removed by heating the object at a fourth temperature for a fourth period of time, the fourth temperature is higher than the second temperature, and the fourth period of time is shorter than the second period of time.

13. The method of claim 12, wherein the fourth temperature is in a range of from about 50 °C to 150 °C, and the fourth period of time is in a range of from about 10 minutes to about 30 minutes.

14. A method, comprising steps of:
forming an inner coating comprising metal oxide nanoparticles on an object by using a first solution comprising metal oxide nanoparticles and a first solvent,
forming an outer coating in contact with the inner coating by using a second solution comprising silicon dioxide nanoparticles and a second solvent; and
strengthening a binding force between the metal oxide nanoparticles and the silicon dioxide nanoparticles by applying a third solution onto the inner coating and the outer coating.

15. The method of claim 14, wherein the third solution is water, ethanol, or any combination thereof.

16. The method of claim 14, wherein the metal oxide nanoparticles comprise TiO₂, and the third solution is water.

17. The method of claim 14, further comprising drying the object to remove the third solution.

18. A coated object, comprising:
an inner coating comprising metal oxide nanoparticles disposed on a surface of an object; and
an outer coating comprising silicon dioxide nanoparticles in contact with the inner coating, wherein the metal oxide nanoparticles and the silicon dioxide nanoparticles are bonded together in an interface between the inner coating and the outer coating.

19. The coated object of claim 18, wherein the metal oxide nanoparticles and the silicon dioxide nanoparticles are covalently bonded together in the interface between the inner coating and the outer coating.

20. The coated object of claim 18, wherein the metal oxide nanoparticles comprise TiO₂.
